# DEMANDE DE BREVET EUROPEEN

(11) **EP 1 475 830 A2**
(43) Date de publication de la demande: **10.11.2004**
(21) Numéro de dépôt: 04300255.9
(22) Date de dépôt: 30.04.2004
(51) Int. Cl.: H01L 21/331

(54) **Procédé de fabrication d'un transistor bipolaire**

(30) Priorité: 02.05.2003 FR 0305419
(71) Demandeur: STMicroelectronics S.A., 92120 Montrouge (FR)
(72) Inventeur: Marty, Michel, 38760 Saint Paul de Varces (FR); Martinet, Bertrand, 38000 Grenoble (FR); Fellous, Cyril, 38130 Echirolles (FR)
(74) Mandataire: de Beaumont, Michel

(57) **Abrégé**

L'invention concerne un procédé de fabrication d'un transistor bipolaire, comportant les étapes suivantes :
former, sur un substrat (1), un premier semiconducteur (2) ;
déposer une couche d'encapsulation (3) gravable par rapport au premier semiconducteur ;
former un bloc sacrificiel au niveau de la jonction base-émetteur ;
découvrir le premier semiconducteur (2) autour d'espaceurs (6-1) formés autour dudit bloc ;
former un deuxième semiconducteur (7) puis un troisième semiconducteur gravable par rapport au deuxième semi-conducteur, à la couche d'encapsulation et aux espaceurs, la somme des épaisseurs du deuxième semiconducteur et de la couche sacrificielle étant égale à la somme des épaisseurs de la couche d'encapsulation et dudit bloc ;
éliminer ledit bloc et la couche d'encapsulation ;
déposer un quatrième semiconducteur (9) ;
éliminer le troisième semiconducteur ; et
graver une couche isolante (11) pour la maintenir sur les parois de l'émetteur et entre celui-ci et le deuxième semiconducteur.

## Description

La présente invention concerne la fabrication de transistors bipolaires dans des circuits intégrés. Plus particulièrement, la présente invention concerne la réalisation d'une structure base-émetteur d'un transistor bipolaire.

Pour optimiser les performances électriques d'un transistor bipolaire, il est souhaitable que le dopage et l'épaisseur de sa région de base intermédiaire entre son collecteur et son émetteur soient contrôlés aussi exactement que possible.

La présente invention vise à proposer un procédé qui permet d'obtenir des transistors bipolaires dont les performances sont meilleures que celles des transistors bipolaires existants.

La présente invention vise à proposer un tel procédé qui permet de définir avec précision l'alignement de la base et de l'émetteur.

La présente invention vise à proposer un tel procédé qui permet de définir une base très fine.

Pour atteindre ces objets, la présente invention prévoit un procédé de fabrication d'un transistor bipolaire dans un substrat monocristallin d'un premier type de conductivité comportant les étapes suivantes :
faire croître sur le substrat au moins une première couche semiconductrice du second type de conductivité ;
déposer au moins une couche d'encapsulation gravable sélectivement par rapport à la couche semiconductrice sous-jacente ;
former un bloc sacrificiel à l'emplacement où doit être formée la jonction base-émetteur du transistor ;
former des espaceurs latéraux autour du bloc ;
découvrir la première couche semiconductrice autour du bloc de part et d'autre des espaceurs latéraux ;
faire croître par épitaxie sélective une deuxième couche semiconductrice fortement dopée du second type de conductivité ;
faire croître par épitaxie sélective une troisième couche semiconductrice gravable sélectivement par rapport à la deuxième couche semiconductrice, par rapport à la couche d'encapsulation et par rapport aux espaceurs latéraux, la somme des épaisseurs de la deuxième couche semiconductrice et de la couche sacrificielle étant sensiblement égale à la somme des épaisseurs de la couche d'encapsulation et du bloc sacrificiel ;
éliminer sélectivement le bloc et la couche d'encapsulation sous-jacente de façon à découvrir la première couche semiconductrice ;
déposer et graver une quatrième couche semiconductrice fortement dopée du premier type de conductivité ;
éliminer la troisième couche semiconductrice ; et
déposer et graver de façon anisotrope une couche isolante de façon à la maintenir en place sur les parois latérales de l'émetteur et entre celui-ci et la deuxième couche semiconductrice.

Selon un mode de réalisation de la présente invention, la couche d'encapsulation est une couche d'oxyde de silicium.

Selon un mode de réalisation de la présente invention, le bloc sacrificiel est formé en déposant et gravant une couche d'oxyde de silicium.

Selon un mode de réalisation de la présente invention, l'étape de formation des espaceurs latéraux comprend les étapes suivantes :
déposer au moins une couche d'encapsulation supplémentaire gravable sélectivement par rapport à ladite couche d'encapsulation reposant sur la première couche semiconductrice du second type de conductivité ;
graver de façon anisotrope les parties planes de la couche d'encapsulation supplémentaire de façon à découvrir les surfaces supérieures de la couche d'encapsulation et du bloc sacrificiel ; et
graver de façon anisotrope la couche d'encapsulation de façon à découvrir la première couche semiconductrice.

Selon un mode de réalisation de la présente invention, deux couches d'encapsulation supplémentaires en nitrure de silicium sont successivement déposées puis gravées.

Selon un mode de réalisation de la présente invention, la deuxième couche semiconductrice est une couche de silicium d'une épaisseur comprise entre 30 et 70 nm.

Selon un mode de réalisation de la présente invention, la troisième couche semiconductrice est une couche de silicium-germanium d'une épaisseur comprise entre 30 et 70 nm.

Selon un mode de réalisation de la présente invention, la quatrième couche semiconductrice est une couche de silicium fortement dopée du premier type de conductivité.

Selon un mode de réalisation de la présente invention, la couche isolante est une couche d'oxyde de silicium.

Selon un mode de réalisation de la présente invention, la première couche semiconductrice est une couche de silicium-germanium formée par épitaxie de façon à ce qu'elle soit constituée d'au moins les quatre zones superposées suivantes :
une zone de silicium-germanium comprenant du carbone ;
une zone de silicium-germanium comprenant du carbone et des dopants du second type de conductivité recherché ;
une zone de silicium-germanium comprenant du carbone ; et
une zone de silicium.

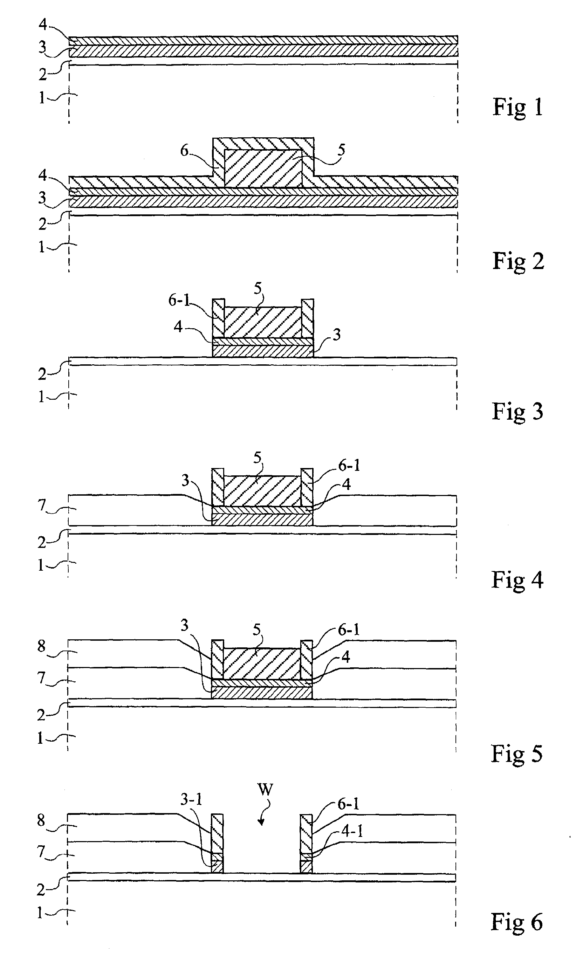

Ces objets, caractéristiques et avantages, ainsi que d'autres de la présente invention seront exposés en détail dans la description suivante de modes de réalisation particuliers faite à titre non-limitatif en relation avec les figures 1 à 10 qui illustrent, en vue en coupe partielle et schématique, des étapes successives d'un procédé de fabrication d'un transistor bipolaire selon un mode de réalisation de la présente invention.

Par souci de clarté, comme cela est habituel dans la représentation des circuits intégrés, les vues en coupe ne sont pas tracées à l'échelle. En outre, de mêmes éléments sont désignés par de mêmes références aux différentes figures. En outre, au fur et à mesure de leur identification, on désignera les différents éléments (base, collecteur...) d'un transistor bipolaire par la référence de la couche ou du matériau qui les constitue.

La présente invention, appliquée à la réalisation d'un transistor bipolaire de type NPN, est décrite ci-après en relation avec les figures 1 à 10.

Comme l'illustre la figure 1, on part d'un substrat semiconducteur monocristallin 1 dopé d'un premier type de conductivité, par exemple N, destiné à constituer le collecteur du transistor bipolaire. Sur le substrat 1, on forme par épitaxie une couche semiconductrice monocristalline 2, de préférence, dopée du second type de conductivité P, destinée à constituer la base du transistor. La couche de base 2 résultant d'une épitaxie, son épaisseur et son niveau de dopage sont déterminés avec précision.

Ensuite, on dépose au moins une couche d'encapsulation, par exemple deux couches 3 et 4. La couche inférieure 3 est gravable sélectivement par rapport au semiconducteur constituant la couche 2 sous-jacente. La couche supérieure 4 est gravable sélectivement par rapport à la couche inférieure 3.

Aux étapes suivantes, illustrées en figure 2, on forme un bloc sacrificiel 5 à l'emplacement où l'on souhaite former l'émetteur du transistor bipolaire. Le bloc 5 est obtenu en déposant puis gravant un matériau gravable sélectivement par rapport à la couche d'encapsulation 4.

Ensuite, l'ensemble de la structure, c'est-à-dire le bloc 5 et la couche d'encapsulation 4 de part et d'autre de celle-ci, est recouverte d'une couche d'encapsulation 6. De préférence, la couche 6 est en un même matériau que la couche 4.

Aux étapes suivantes, illustrées en figure 3, on procède à des gravures anisotropes, sélectives, successives des couches 6 et 4 de façon à ne laisser en place que des espaceurs 6-1 le long des parois latérales du bloc 5. Ensuite, on grave la couche 3 de façon à découvrir la couche de base 2. La couche 3 est maintenue en place uniquement sous la partie restante de la couche 4. Si le bloc 5 est en un même matériau que la couche 3, une partie supérieure du bloc 5 est alors éliminée, comme cela est représenté.

Aux étapes suivantes, illustrées en figure 4, on procède à une croissance par épitaxie d'une couche semiconductrice 7. Les conditions de croissance sont choisies pour qu'il ne se produise pas de dépôt ailleurs que sur les parties semiconductrices découvertes, c'est-à-dire uniquement les parties découvertes de la couche 2. La couche 7, très fortement dopée de type P, est destinée à former un contact de base.

Ensuite, comme l'illustre la figure 5, on procède à un nouveau dépôt épitaxial sélectif pour former une couche sacrificielle 8 uniquement sur la couche 7. La couche 8 est en un matériau gravable sélectivement par rapport à celui de la couche de contact de base 7. L'épaisseur de la couche 8 est choisie en fonction de l'épaisseur de la couche 7 de façon que la surface supérieure de la couche 8 soit sensiblement coplanaire avec la surface supérieure du bloc 5.

Aux étapes suivantes, illustrées en figure 6, on élimine par gravure sélective le bloc sacrificiel 5. On grave sélectivement la portion de la couche 4 ainsi découverte et la portion sous-jacente de la couche 3. On découvre ainsi partiellement la base intrinsèque 2 au fond d'une fenêtre W définie par les espaceurs latéraux 6-1 et les portions restantes 4-1 et 3-1 des couches 4 et 3 disposées sous les espaceurs 6-1.

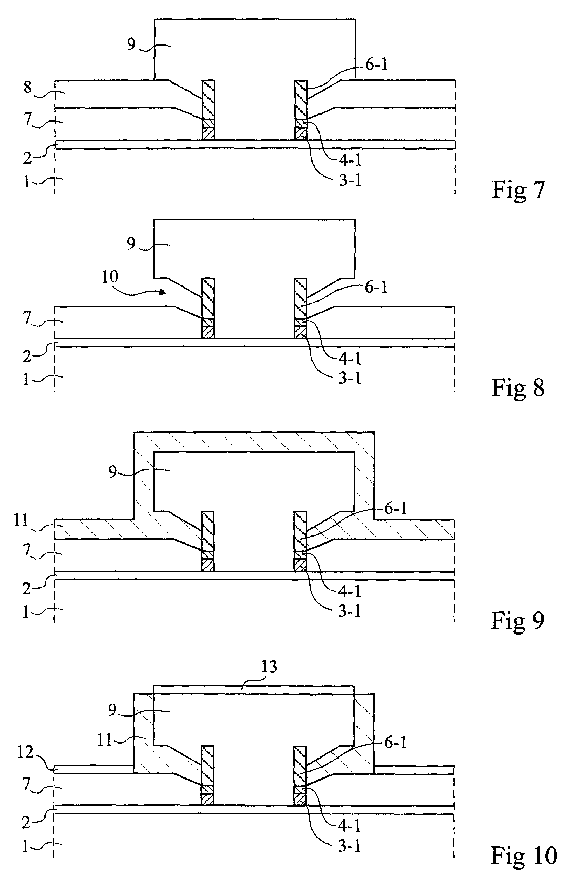

Ensuite, comme l'illustre la figure 7, on dépose une couche 9 d'un matériau semiconducteur. La couche 9, fortement dopée de type N, est destinée à former l'émetteur du transistor bipolaire. Cette couche 9 est ensuite gravée pour rester en place dans la fenêtre W. Inévitablement, cette couche 9 déborde au-dessus de la couche sacrificielle 8 à l'extérieur des espaceurs 6-1. Le matériau de la couche sacrificielle 8 est choisi de façon à être gravable sélectivement par rapport au matériau semiconducteur de la couche 9.

A l'étape illustrée en figure 8, on élimine totalement et sélectivement la couche sacrificielle 8, ce qui laisse un vide 10 entre l'émetteur 9 et le contact de base 7. Ce vide 10 évite tout court-circuit entre l'émetteur 9 et le contact de base 7.

Aux étapes suivantes, illustrées en figure 9, on dépose une couche isolante 11. La couche 11 est déposée de façon à remplir le vide 10 et à recouvrir l'ensemble de la structure.

Comme l'illustre la figure 10, la couche 11 est gravée de façon anisotrope pour découvrir la surface supérieure de l'émetteur 9 et la surface supérieure de la couche de contact de base 7. Les portions de la couche 11 restantes après gravure remplissent le vide 10 et recouvrent les parois latérales de l'émetteur 9. On assure ainsi une isolation de l'émetteur 9 par rapport au contact de base 7.

On procède ensuite, de préférence, à une étape propre à former des couches fortement conductrices : une couche 12 sur la couche de contact de base 7 et une couche 13 sur la couche d'émetteur 9. Par exemple, dans les filières standard à base de silicium, on effectuera une siliciuration de façon à former des couches 12 et 13 d'un siliciure métallique.

Le procédé se poursuit ensuite par des étapes courantes de réalisation d'un transistor bipolaire telles que, par exemple, la formation de métallisations (non représentées) solidaires de ces surfaces...

Comme le comprendra l'homme de l'art, seules les étapes nécessaires à la compréhension de la présente invention ont été décrites précédemment. L'homme de l'art saura compléter le procédé décrit précédemment pour former un transistor bipolaire. En particulier, la structure du collecteur n'a pas été décrite ici. Elle pourra comprendre de façon classique une couche enterrée fortement dopée de type N surmontée d'une région d'implantation profonde également fortement dopée de type N. Pour préserver la qualité de la couche de base 2, cette implantation profonde sera effectuée avant sa croissance décrite en relation avec la figure 1.

A titre d'exemple non-limitatif, les matériaux et épaisseurs des différents couches et éléments utilisés pour réaliser un transistor bipolaire de type NPN selon la présente invention sont les suivants :
- substrat 1 : silicium, dopé de type N ;
- couche de base 2 : silicium ou silicium-germanium SiGe ou multicouche de silicium et de silicium-germanium SiGe, d'une épaisseur totale de 10 à 100 nm, par exemple de 50 nm. De préférence, la croissance épitaxiale de la couche de base 2 est effectuée de façon à ce qu'elle soit constituée de quatre zones superposées :
   + une première zone de SiGe, portée par le substrat 1 et comprenant du carbone (C) ;
   + une deuxième zone de SiGe, avec une proportion de 0 à 50% de germanium, comprenant du carbone et des dopants propres à lui conférer le type de conductivité recherché, par exemple, des atomes de bore (B) à une concentration active comprise entre 5.10¹⁸ et 10²¹ atomes/cm³ ;
   + une troisième zone de SiGe, comprenant du carbone ; et
   + une quatrième zone de silicium.

Le carbone est incorporé dans les différentes zones de façon que celles-ci demeurent conductrices ;
- première couche d'encapsulation 3 : oxyde de silicium (SiO₂), d'une épaisseur comprise entre 5 et 20 nm ;
- deuxième couche d'encapsulation 4 : nitrure de silicium (Si₃N₄), d'une épaisseur comprise entre 10 et 20 nm ;
- bloc sacrificiel 5 : oxyde de silicium, d'une épaisseur comprise entre 80 et 150 nm, par exemple de 100 nm ;
- couche d'encapsulation 6 : nitrure de silicium, d'une épaisseur comprise entre 50 et 100 nm ;
- couche de contact de base 7 : silicium, d'une épaisseur comprise entre 30 et 70 nm, par exemple de 50 nm, dopé de type P, par exemple avec du bore à une concentration supérieure à 10²⁰ atomes/cm³ ;
- couche sacrificielle 8 : couche de silicium-germanium, d'une épaisseur comprise entre 30 et 70 nm, par exemple de 50 nm. Pour fixer la sélectivité de gravure entre la couche de contact de base 7 et la couche 8, celle-ci peut éventuellement être dopée de type N ou P in situ lors de sa croissance épitaxiale ;
- couche d'émetteur 9 : silicium, de préférence dopé in situ de type N ;
- couche isolante 11 : oxyde de silicium.

Parmi les avantages des transistors bipolaires selon la présente invention, on pourra noter les avantages suivants :
- l'utilisation du bloc sacrificiel pour définir la fenêtre d'émetteur permet d'atteindre des dimensions très faibles, inférieures à 0,1 µm ;
- de telles dimensions sont atteintes également lorsque la base est très fine, par exemple comprise entre 10 et 30 nm ;
- de telles dimensions de la fenêtre et/ou de la base sont atteintes avec un procédé permettant un auto-alignement de l'émetteur 9 et du contact de base 7 par rapport à la base 2 ;
- les espaceurs latéraux 6-1 entourant la zone d'émetteur 9 résultent d'un dépôt d'une couche mince 6 de nitrure de silicium (qui peut avoir une épaisseur de l'ordre de 50 à 100 nm seulement comme on l'a vu précédemment). La région de contact de base 7 sera alors très peu éloignée de la région de base intrinsèque 2, d'où il résulte que la région de base extrinsèque entre ces régions aura une épaisseur minimale ce qui réduit la résistance d'accès à la base ;
- un bon isolement entre l'émetteur 9 et la région de contact de base 7, qui résulte de l'élimination de la couche sacrificielle 8. Les risques de court-circuit sont alors extrêmement réduits.

Bien entendu, la présente invention est susceptible de diverses variantes et modifications qui apparaîtront à l'homme de l'art. En particulier, on a considéré précédemment la présente invention dans le cas de la formation d'un transistor bipolaire de type NPN. Toutefois, la présente invention s'applique également à la réalisation de transistors de type PNP. En outre, l'homme de l'art saura compléter la structure décrite précédemment de façon appropriée pour obtenir un dispositif particulier. Seules les étapes et éléments nécessaires à la compréhension de l'invention ont été décrits précédemment. Ainsi, l'homme de l'art saura mettre en oeuvre, avant de former la base 2 pour obtenir la structure de la figure 1, des étapes courantes de traitement du substrat destinées à former des couches ou zones spécifiquement dopées ou d'isolement spécifiques nécessaires au fonctionnement du transistor résultant. De même, l'homme de l'art saura adapter les natures et dimensions des diverses couches à une filière technologique spécifique tout en respectant les règles de gravure et d'épaisseur décrites précédemment.

## Revendications

1. Procédé de fabrication d'un transistor bipolaire dans un substrat monocristallin (1) d'un premier type de conductivité (N), **caractérisé en ce qu'**il comporte les étapes suivantes :
faire croître sur le substrat au moins une première couche semiconductrice (2) du second type de conductivité (P) ;
déposer au moins une couche d'encapsulation (3) gravable sélectivement par rapport à la couche semiconductrice sous-jacente ;
former un bloc sacrificiel (5) à l'emplacement où doit être formée la jonction base-émetteur du transistor ;
former des espaceurs latéraux (6-1) autour dudit bloc ;
découvrir la première couche semiconductrice (2) autour dudit bloc de part et d'autre des espaceurs latéraux ;
faire croître par épitaxie sélective une deuxième couche semiconductrice (7) fortement dopée du second type de conductivité ;
faire croître par épitaxie sélective une troisième couche semiconductrice (8) gravable sélectivement par rapport à la deuxième couche semiconductrice, par rapport à la couche d'encapsulation et par rapport aux espaceurs latéraux, la somme des épaisseurs de la deuxième couche semiconductrice et de la couche sacrificielle étant sensiblement égale à la somme des épaisseurs de la couche d'encapsulation et du bloc sacrificiel ;
éliminer sélectivement ledit bloc et la couche d'encapsulation sous-jacente de façon à découvrir la première couche semiconductrice ;
déposer et graver une quatrième couche semiconductrice (9) fortement dopée du premier type de conductivité ;
éliminer la troisième couche semiconductrice ; et
déposer et graver de façon anisotrope une couche isolante (11) de façon à la maintenir en place sur les parois latérales de l'émetteur et entre celui-ci et la deuxième couche semiconductrice (7).

2. Procédé selon la revendication 1, **caractérisé en ce que** la couche d'encapsulation (3) est une couche d'oxyde de silicium.

3. Procédé selon la revendication 1, **caractérisé en ce que** le bloc sacrificiel (5) est formé en déposant et gravant une couche d'oxyde de silicium.

4. Procédé selon la revendication 1, **caractérisé en ce que** l'étape de formation des espaceurs latéraux comprend les étapes suivantes :
déposer au moins une couche d'encapsulation supplémentaire (6) gravable sélectivement par rapport à ladite couche d'encapsulation (3) reposant sur la première couche semiconductrice (2) du second type de conductivité (P) ;
graver de façon anisotrope les parties planes de la couche d'encapsulation supplémentaire de façon à découvrir les surfaces supérieures de la couche d'encapsulation (3) et du bloc sacrificiel (5) ; et
graver de façon anisotrope la couche d'encapsulation (3) de façon à découvrir la première couche semiconductrice (2).

5. Procédé selon la revendication 4, **caractérisé en ce que** deux couches d'encapsulation supplémentaires (4, 6) en nitrure de silicium sont successivement déposées puis gravées.

6. Procédé selon la revendication 1, **caractérisé en ce que** la deuxième couche semiconductrice (7) est une couche de silicium d'une épaisseur comprise entre 30 et 70 nm.

7. Procédé selon la revendication 1, **caractérisé en ce que** la troisième couche semiconductrice (8) est une couche de silicium germanium d'une épaisseur comprise entre 30 et 70 nm.

8. Procédé selon la revendication 1, **caractérisé en ce que** la quatrième couche semiconductrice (9) est une couche de silicium fortement dopée du premier type de conductivité (N).

9. Procédé selon la revendication 1, **caractérisé en ce que** la couche isolante (11) est une couche d'oxyde de silicium.

10. Procédé selon la revendication 1, **caractérisé en ce que** la première couche semiconductrice (2) est une couche de silicium-germanium formée par épitaxie de façon à ce qu'elle soit constituée d'au moins les quatre zones superposées suivantes :
une zone de silicium-germanium comprenant du carbone (C) ;
une zone de silicium-germanium comprenant du carbone et des dopants du second type de conductivité recherché (P) ;
une zone de silicium-germanium comprenant du carbone ; et
une zone de silicium.
